# EUROPÄISCHE PATENTSCHRIFT

(11) **EP 0 538 239 B1**
(45) Veröffentlichungstag und Bekanntmachung des Hinweises auf die Patenterteilung: **18.12.1996**
(21) Anmeldenummer: 92890225.3
(22) Anmeldetag: 16.10.1992
(51) Int. Cl.: H01L 27/02

(54) **Schaltung zum Spannungsschutz der Speisespannung einer integrierten CMOS-Schaltung**
Circuit for the voltage protection of the supply voltage of a CMOS integrated circuit
Circuit pour la protection en tension de la tension d'alimentation d'un circuit intégré CMOS

(30) Priorität: 16.10.1991 AT 2061/91
(43) Veröffentlichungstag der Anmeldung: 21.04.1993
(73) Patentinhaber: AUSTRIA MIKRO SYSTEME INTERNATIONAL AKTIENGESELLSCHAFT, A-8141 Unterpremstätten (AT)
(72) Erfinder: Trontelj, Janez, Prof. Dr., 61000 Laibach, Slowenien (SI); Trontelj, Lojze, Prof. Dr., 61000 Laibach, Slowenien (SI); Pletersek, Anton, Dr., 61000 Laibach, Slowenien (SI); Kunc, Vinko Mag., 61000 Laibach, Slowenien (SI)
(74) Vertreter: Haffner, Thomas M., Dr.

(56) Entgegenhaltungen:
- EP-A- 0 276 850

## Beschreibung

Die Erfindung betrifft eine Schaltung zum Spannungsschutz der Speisespannung einer integrierten CMOS-Applikationsschaltung, welche am Substrat ausgebildet ist und einen bipolaren Transistor umfaßt.

Die integrierten CMOS-Schaltungen, welche in einem Milieu wirken, wo es in der Speisespannung zu Überspannungsübergangserscheinungen kommen kann, müssen mit einem Spannungsschutz ausgestattet sein. In der Regel wird das mit Hilfe von Außenelementen durchgeführt; das sind Elemente, welche nicht am gleichen Substrat wie die integrierte CMOS-Schaltung angeordnet sind. Es ist aber auch bereits ein mit Innenelementen ausgeführter Spannungsschutz bekannt, bei welchem ein Reihenwiderstand (bezugnehmend auf die gespeiste Schaltung) aus polykristallinem Silizium und eine parallele Zenerdiode am Substrat angebracht sind, wobei der Widerstand nicht im Substrat eingebettet ist, so daß Isolationsprobleme nicht bestehen. Der Nachteil dieser Ausführung liegt darin, daß in einer der beiden Speisespannungszuführungen wegen des Reihenwiderstandes die Stromergiebigkeit dieser Speisespannung im Bereich der normalen Speisespannungen begrenzt ist. Sie wird daher nur bei solchen Schaltungen angewendet, wo keine große Stromkapazität der Speisespannung benötigt wird.

Die EP-A-276 850 beschreibt die Verwendung eines parasitären bipolaren Transistors als paralleles Element zur Begrenzung der Versorgungsspannung. Sein Kollektor und Emitter sind mit den Versorgungsanschlüssen verbunden und die Basis durch den Substratwiderstand mit dem Emitter verbunden.

Aufgrund der Mängel der bis jetzt bekannten Spannungsschutzschaltungen für die Speisespannung von integrierten CMOS-Schaltungen zielt die Erfindung darauf ab, eine Schaltung der beschriebenen Art mit der zur speisenden Schaltung auf einem gemeinsamen Substrat auszuführen, wobei die Schaltung im Bereich der normalen Speisespannung die volle Stromkapazität haben soll. Im besonderen zielt die Erfindung hiebei darauf ab, eine derartige Spannungsschutzschaltung ohne Änderung des Herstellungsverfahrens in einem CMOS-Prozeß herstellen zu können und gleichzeitig die bei einer derartigen Integration zu befürchtenden Isolationsprobleme zu lösen.

Zur Lösung dieser Aufgabe ist die erfindungsgemäße Schaltung im wesentlichen dadurch gekennzeichnet, daß der positive Speisespannungsanschluß mit einem ersten Kontakt, welcher der Kollektor des bipolaren Transistors ist, an das Substrat angeschlossen ist, dessen Basis mit der Kathode einer ersten Zenerdiode und mit der zweiten Klemme eines Widerstandes aus polykristallinem Silizium verbunden ist, dessen erste Klemme mit dem Kollektor verbunden ist, wobei der Emitter mit dem Innenspeisespannungsanschluß und weiters mit einem zweiten Kontakt am Substrat und mit der Kathode einer zweiten Zenerdiode verbunden ist, deren Anode mit dem negativen Speisespannungsanschluß und mit der Anode der ersten Zenerdiode verbunden ist, daß der Kollektor von der Insel, auf welcher Emitter und Basis angebracht sind, in einem Abstand in der Größe der 1,5-fachen Tiefe dieser Insel angeordnet ist, daß der zweite Kontakt am Substrat den Transistor und die erste Zenerdiode von der zweiten Zenerdiode und der Schaltung trennt und der Bereich zwischen dem Kollektor und dem zweiten Kontakt für jenen Transistorentyp, welcher dem Leitfähigkeitstyp des Substrates entgegengesetzt ist, verboten ist und daß die Entfernung zwischen dem Transistors und dem zweiten Kontakt mindestens das Fünffache der Substratstärke beträgt. Durch die Anordnung des Transistors wird dabei zunächst die Möglichkeit geschaffen, im Bereich der normalen Speisespannungen Einschränkungen in bezug auf die Stromkapazität zu vermeiden, da dieser Transistor im normalen Betriebszustand leitend ist.

Die beschriebene Anordnung bewirkt des weiteren, daß der Transistor im Falle von Überspannungen gesperrt wird und der sich im Substrat zwischen dem Kollektoranschluß und dem Kontakt am Substrat befindliche Widerstand die Stromversorgung der CMOS-Schaltung aufrecht erhält und effektiv als stromlimitierender Parallelwiderstand zum Transistor in Erscheinung tritt. Von wesentlicher Bedeutung in diesem Zusammenhang sind die topographischen Bemaßungen des Anspruches hinsichtlich der Anordnung der Elemente der Schutzschaltung zueinander sowie zur CMOS-Schaltung. Sie bewirken, daß Ströme und Feldstärken sich im Überspannungsfall nicht destruktiv auswirken können und daß andererseits die sich bei der Ausbildung am gleichen Substrat manifestierenden Isolationsprobleme befriedigend gelöst werden. Zusammenfassend wird auf diese Weise eine einfach herzustellende, integrierte Spannungsschutzschaltung gebildet, welche im CMOS-Herstellungsprozeß ohne Modifikationen dieses Herstellungsverfahrens realisiert werden kann, und welche somit einen wirkungsvollen Einzelschutz für jede integrierte Schaltung gewährleistet.

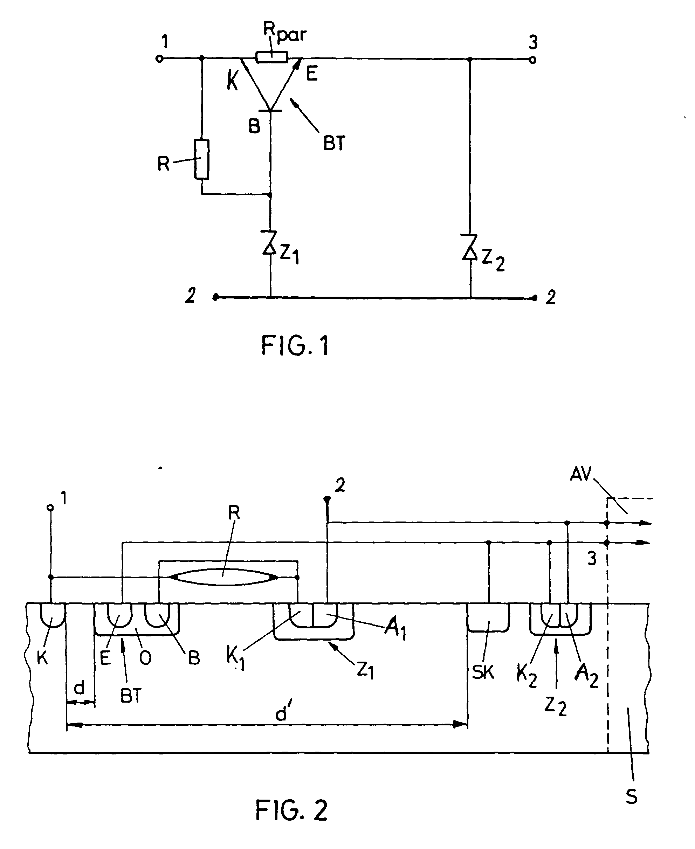

In der Folge wird die Erfindung an Hand eines in der Zeichnung dargestellten Ausführungsbeispieles näher beschrieben, wobei: Fig.1 ein Ersatzschaltungsschema des erfindungsgemäßen Spannungsschutzes der Speisespannung einer integrierten CMOS-Applikationsspannung darstellt und Fig.2 im Querschnitt ein Substrat mit der Schaltung gemäß der Erfindung darstellt.

Die Schaltung zum Spannungsschutz der Speisespannung einer integrierten CMOS-Applikationsschaltung AV ist am Substrat S gemeinsam mit dieser Schaltung ausgeführt (Fig.2). Der positive Außenanschluß der Speisespannung 1 ist mit dem ersten Kontakt am Substrat bzw. Kollektor K des bipolaren Schutztransistors BT verbunden, sowie mit einem zum Schutztransistor BT parallelen Widerstand Rₚₐᵣ, der zwischen dem ersten Kontakt am Substrat und dem zweiten Kontakt am Substrat SK (Fig.2) wirkt. Die Basis B des Transistors BT ist an die Kathode K1 einer ersten Zenerdiode Z1 und an die zweite Klemme eines Widerstandes R aus polykristallinem Silizium mit einem Widerstand von ca. 1kΩ angeschlossen. Die erste Klemme bzw. der erste Anschluß des Widerstandes R ist am Kollektor K angeschlossen. Der Emitter E ist an den Innenanschluß der Speisespannung 3 und an den zweiten Kontakt am Substrat SK sowie an die Kathode K2 einer zweiten Zenerdiode Z2 angeschlossen. Die Zenerdiode Z2 hat die gleiche Durchschlagsspannung wie die Zehnerdiode Z1. Die Anode A2 der Zenerdiode Z2 ist aber an den negativen Außen- und Innenanschluß 2 der Speisespannung sowie an die Anode Al der Zenerdiode Z1 angeschlossen.

Der Kollektor K steht zur Insel O, in welcher Emitter und Basis angebracht sind, in einem Abstand d, welcher die 1,5-fache Tiefe der Insel O beträgt. Den gewünschten Wert Rₚₐᵣ von ca. 200 Ohm erreicht man, indem der Substratkontakt SK in einem Abstand d', der die 5-fache Stärke des Substrates S beträgt, angebracht wird. Der Kollektor K ist im Grunde einer der beiden Kontakte mit dem Substrat S und muß auf der entferntesten Stelle des Substrates in bezug auf den zweiten Kontakt am Substrat SK angebracht werden. Das Verhältnis zwischen dem Umfang und der Fläche des Kollektors K muß maximal sein. Der andere Kontakt am Substrat SK teilt das Substrat S so durch die ganze Breite, daß er den bipolaren Transistor BT und die Zenerdiode Z1 von der Zenerdiode Z2 und der Schaltung AV trennt. Die Entfernung d' zwischen dem Transistor BT und dem zweiten Kontakt am Substrat SK soll mindestens die 5-fache Stärke des Substrates S betragen. Das Anschlußproblem auf dem Substrat S ist somit mit den zwei Kontakten K und SK am Substrat auf verschiedenem Potential gelöst, wobei aber der Widerstand zwischen den beiden so groß als möglich sein muß.

Auf die beschriebene Art wurde das Problem des Anschlusses des Transistors BT auf dem Substrat S gelöst. Der Bereich des Substrates S an jeder Seite des SK-Kontaktes, wo sich der Transistor BT befindet, ist für Transistoren des Typus p eine verbotene Zone, wobei vorausgesetzt wird, daß das Substrat vom Typus n ist.

Die beschriebene Anordnung im bipolaren Transistor sichert eine ausreichend hohe Durchschlagsspannung zwischen dem Kollektor K und dem Emitter E und ermöglicht auf diese Weise die Anwendung des bipolaren Transistors BT in der vorgeschlagenen Schaltung.

Die Schaltung wirkt folgendermaßen: solange die Speisespannung kleiner als die Durchschlagsspannung Vz der Zenerdioden Z1, Z2 ist, ist der effektive Widerstand Re der Schutzschaltung mit Re = R/β bestimmt, wobei R den Widerstand zwischen der Basis B und dem Kollektor K und β die Verstärkung des Transistors BT bedeuten.

Wenn aber die Außenspeisespannung angestiegen ist und die Innenspeisespannung den Wert Vz erreicht hat, so sperrt der Transistor BT. Auch die Basis B ist bezüglich Vz begrenzt und die Verbindung Basis - Emitter ist nicht mehr leitend polarisiert. Zwischen der Innen- und Außenspeisespannung verbleibt nur der relativ hohe parallele Widerstand des Substrates, welcher die Schaltung AV schützt.

Die Schaltung findet ihre Anwendung überall dort, wo eine integrierte CMOS-Schaltung vor Spannungsimpulsen geschützt werden soll.

## Patentansprüche

1. Schaltung zum Spannungsschutz der Speisespannung einer integrierten CMOS-Applikationsschaltung (AV), welche am Substrat (S) ausgebildet ist und einen bipolaren Transistor (BT) umfaßt, dadurch gekennzeichnet, daß der positive Speisespannungsanchluß (1) mit einem ersten Kontakt, welcher der Kollektor (K) eines bipolaren Transistors (BT) ist, an das Substrat (S) angeschlossen ist, dessen Basis mit der Kathode (K1) einer ersten Zenerdiode (Z1) und mit der zweiten Klemme eines Widerstandes (R) aus polykristallinem Silizium verbunden ist, dessen erste Klemme mit dem Kollektor (K) verbunden ist, wobei der Emitter (E) mit dem Innenspeisespannungsanschluß (3) und weiters mit einem zweiten Kontakt am Substrat (SK) und mit der Kathode (K2) einer zweiten Zenerdiode (Z2) verbunden ist, deren Anode (A2) mit dem negativen Speisespannungsanschluß (2) und mit der Anode (Al) der ersten Zenerdiode (Z1) verbunden ist, daß der Kollektor (K) von der Insel (O), in welcher Emitter (E) und Basis (B) angebracht sind, in einem Abstand in der Größe der 1,5-fachen Tiefe dieser Insel (O) angeordnet ist, daß der zweite Kontakt (SK) am Substrat (S) den Transistor (BT) und die erste Zenerdiode (Z1) von der zweiten Zenerdiode (Z2) und der Schaltung (AV) trennt und der Bereich zwischen dem Kollektor (K) und dem zweiten Kontakt (SK) für jenen Transistorentyp, welcher dem Leitfähigkeitstyp des Substrates entgegengesetzt ist, verboten ist und daß die Entfernung zwischen dem Transistor (BT) und dem zweiten Kontakt (SK) mindestens das Fünffache der Substratstärke beträgt.

## Claims

1. Voltage protection circuit for the supply voltage of an integrated CMOS application circuit (AV), which is formed on the substrate (S) and comprises a bipolar transistor (BT), characterized in that the positive supply voltage terminal (1) is connected to the substrate (S) by a first contact, which is the collector (K) of a bipolar transistor (BT), the base of which is connected to the cathode (K1) of a first Zener diode (Z1) and to the second terminal of a resistor (R) made of polycrystalline silicon, the first terminal of which is connected to the collector (K), the emitter (E) being connected to the internal supply voltage terminal (3) and further to a second contact on the substrate (SK) and to the cathode (K2) of a second Zener diode (Z2), the anode (A2) of which is connected to the negative supply voltage terminal (2) and to the anode (A1) of the first Zener diode (Z1), that the collector (K) is spaced apart from the island (O), in which emitter (E) and base (B) are provided, by a distance corresponding to 1.5 times the depth of said island (O), that the second contact (SK) on the substrate (S) separates the transistor (BT) and the first Zener diode (Z1) from the second Zener diode (Z2) and the circuit (AV) and the region between the collector (K) and the second contact (SK) is forbidden to the type of transistor which is opposed to the conductivity type of the substrate, and that the distance between the transistor (BT) and the second contact (SK) is at least five times the thickness of the substrate.

## Revendications

1. Circuit pour la protection en tension d'alimentation d'un circuit intégré CMOS (AV) réalisé sur le substrat (S) et comprenant un transistor bipolaire (BT), caractérisé en ce que la borné positive d'alimentation (1) est connectée au substrat (S), par un premier contact constituant le collecteur (K) d'un transistor bipolaire (BT) dont la base est reliée à la cathode (K1) d'une première diode Zener (Zl) et à la deuxième borne d'une résistance (R) en silicium polycristallin dont la première borne est reliée au collecteur (K), l'émetteur (E) étant relié, d'une part, à la borne d'alimentation interne (3) et, d'autre part, à un deuxième contact (SK) sur le substrat (S) et à la cathode (K2) d'une deuxième diode Zener (Z2)l'anode (A2) de cette dernière étant reliée à la borne négative d'alimentation (2) et à la première anode (A1) de la diode Zener (Z1), en ce que le collecteur (K) se trouve à un écartement de l'îlot (O) dans lequel l'émetteur (E) et la base (B) sont installés, correspondant à 1,5 fois la profondeur dudit îlot (O), en ce que le deuxième contact (SK) sur le substrat (S) sépare le transistor (BT) et la première diode Zener (Z1) de la deuxième diode Zener (Z2) et du circuit CMOS (AV), la zone comprise entre le collecteur (K) et le deuxième contact (SK) étant interdite pour le type de transistor qui est opposé au type de conductivité du substrat et en ce que l'écartement entre le transistor (BT) et le deuxième contact (SK) correspond à au moins 5 fois l'épaisseur du substrat.
